# EUROPÄISCHE PATENTSCHRIFT

(11) **EP 2 983 458 B1**
(45) Veröffentlichungstag und Bekanntmachung des Hinweises auf die Patenterteilung: **12.07.2023**
(21) Anmeldenummer: 15176966.8
(22) Anmeldetag: 16.07.2015
(51) Int. Cl.: H05K 3/30, F21K 99/00, H05K 3/34, H05K 3/00

(54) **VERFAHREN ZUM BEFESTIGEN EINER SMD-HALBLEITERLICHTQUELLE AUF EINER LEITERPLATTE EINES KRAFTFAHRZEUGSCHEINWERFERS**
METHOD FOR FIXING A SMD SEMICONDUCTOR LIGHT SOURCE ON A CIRCUIT BOARD OF A HEADLIGHT OF A VEHICLE
PROCEDE DE FIXATION D'UNE SOURCE LUMINEUSE SEMI-CONDUCTRICE SMD SUR UNE CARTE DE CIRCUITS IMPRIMES D'UN PHARE DE VEHICULE AUTOMOBILE

(30) Priorität: 06.08.2014 DE 102014215606
(43) Veröffentlichungstag der Anmeldung: 10.02.2016
(73) Patentinhaber: Marelli Automotive Lighting Reutlingen (Germany) GmbH, 72762 Reutlingen (DE)
(72) Erfinder: Gottheil, Martin, 72127 Kusterdingen (DE); Schmid, Oliver, 72149 Neustetten (DE)
(74) Vertreter: DREISS Patentanwälte PartG mbB

(56) Entgegenhaltungen:
- EP-A1- 0 307 990
- AT-B1- 513 747
- DE-A1- 3 445 625
- US-A- 5 155 904
- US-A1- 2009 134 529
- US-A1- 2013 075 031

## Beschreibung

### Stand der Technik

Die vorliegende Erfindung betrifft ein Verfahren zum Befestigen einer SMD-Halbleiterlichtquelle auf einer Leiterplatte nach dem Oberbegriff des Anspruchs 1. Ein solches Verfahren ist aus der US 5 155 904 A bekannt.

Die Druckschrift AT 513 747 B1 offenbart ein Verfahren zur Herstellung eines mit wenigstens einer oberflächenmontierten LED bestückten Schaltungsträgers.

Die Druckschrift US 2009/0134529 A1 offenbart ein Verfahren zur Herstellung von Leiterplattenmodule.

Es ist ganz allgemein bekannt, SMD-Halbleiterlichtquellen wie Leuchtdioden oder Laserdioden von Scheinwerfern auf eine zum Halten, Ansteuern und Versorgen der Halbleiterlichtquellen mit elektrischer Energie eingerichtete Leiterplatte aufzulöten. Die Abkürzung SMD steht bekanntlich für surface mounted device und bezeichnet Bauteile, die ohne aus dem Bauteil heraus ragende Anschlussdrähte auf Leiterplatten aufgesetzt und mit diesen verlötet werden. Die Bauteile sind in eine Vergussmasse eingegossen und besitzen metallische Kontakte, die in der Regel bündig mit der Vergussmasse abschließen und damit eine Kontaktierung erlauben.

Bei dem eingangs genannten, per se bekannten Verfahren zum Befestigen einer SMD-Halbleiterlichtquelle auf einer Leiterplatte eines Kraftfahrzeugscheinwerfers wird in einem Lot-Aufbringungsschritt Lot an vorbestimmten Stellen der Leiterplatte und/oder an vorbestimmten Stellen der SMD-Halbleiterlichtquelle aufgebracht.

Das Lot wird dabei zum Beispiel in Form einer Lötpaste aufgebracht. Die bestimmten Stellen sind typischerweise Enden von Leiterbahnen auf der Leiterplatte, an denen ein Kontakt mit einem metallischen Kontakt des aufzusetzenden SMD-Bauteils hergestellt werden soll.

In einem weiteren Schritt erfolgt ein Positionieren der SMD-Halbleiterlichtquelle auf der Leiterplatte in einer Position, in der in weiteren Schritten eine Lötverbindung hergestellt wird. In einem Lötschritt wird eine Lötverbindung durch vorübergehendes Aufschmelzen des Lotes in einem Lötofen und Abkühlen des Lotes hergestellt.

Bei Halbleiterlichtquellen für Scheinwerfer ist es sehr wichtig, dass die Halbleiterlichtquelle im verlöteten Endzustand eine möglichst genau definierte und mit nur möglichst geringen Toleranzen behaftete Position besitzt, um die photometrischen Anforderungen an eine regelkonforme Lichtverteilung des Scheinwerfers zu erfüllen.

Es hat sich gezeigt, dass die Positionstoleranzen bei dem bekannten Verfahren im Endzustand noch unerwünscht groß sind.

Vor diesem Hintergrund besteht die Aufgabe der Erfindung in der Angabe eines Verfahrens der eingangs genannten Art, mit dem sich im Endzustand geringere und damit verbesserte Lageungenauigkeien (Toleranzen) von Halbleiterlichtquellen in Kraftfahrzeugscheinwerfern ergeben.

Diese Aufgabe wird mit den Merkmalen des Anspruchs 1 gelöst. Von dem eingangs genannten, per se bekannten Verfahren unterscheidet sich die vorliegende Erfindung durch die kennzeichnenden Merkmale des Anspruchs 1.

Bei dem erfindungsgemäßen Verfahren wird vor dem Aufschmelzen des Lotes Kleber an vorbestimmten Stellen der Leiterplatte und/oder der SMD-Halbleiterlichtquelle aufgebracht, und die SMD-Halbleiterlichtquelle wird in der durch den Positionierungsschritt erreichten Position mit der Leiterplatte verklebt.

Das Verkleben erfolgt vor dem Aufschmelzen des Lotes. Dieses Vorgehen basiert auf der Erkenntnis, dass die unerwünschten Veränderungen der Lichtquellenposition zum Beispiel durch ein geringfügiges Verschwimmen und/oder Verkippen der SMD-Halbleiterlichtquelle im flüssigen Lot, das aufgrund seiner hohen Dichte vergleichsweise große Auftriebskräfte erzeugt, auftreten. Durch das nach der Positionierung der Halbleiterlichtquelle und vor dem Aufschmelzen des Lotes erfolgende Verkleben der Halbleiterlichtquelle mit der Leiterplatte in der im

Positionierungsschritt erreichten Position wird eine beim anschließenden Aufschmelzen und Abkühlen des Lotes unerwünschte Änderung der Änderung der Position der Halbleiterlichtquelle wirkungsvoll vermieden.

Mit den verringerten Toleranzen geht eine Verringerung der Ausschussquote beim Herstellen der Scheinwerfer einher. Darüber hinaus wird die Einhaltung der photometrischen Anforderungen verbessert.

Erfindungsgemäß erfolgt das Verkleben und das Aufschmelzen des Lotes in einem Lötofen, wobei das Verklebung vor dem Aufschmelzen des Lotes erfolgt.

Bevorzugt wird ein durch Ultraviolettstrahlung aushärtender Kleber verwendet, der vor dem Aufschmelzen des Lotes mit ultraviolettem Licht bestrahlt wird.

Erfindungsgemäß wird die SMD-Halbleiterlichtquelle solange mit einem zu Platzierung der SMD-Halbleiterlichtquelle auf der Leiterplatte verwendeten Handlingsystem gehalten, bis der aushärtende Klebstoff eine für das Festhalten der SMD-Halbleiterlichtquelle ausreichende Festigkeit entwickelt hat.

Eine weitere bevorzugte Ausgestaltung des Verfahrens zeichnet sich dadurch aus, dass das Aufbringen des Klebers vor dem Platzieren der Halbleiterlichtquellen auf der Leiterplatte erfolgt.

Bevorzugt ist auch, dass der Kleber nach dem Platzieren der Halbleiterlichtquellen auf die Leiterplatte aufgebracht wird.

Erfindungsgemäß erfolgt das Positionieren der Halbleiterlichtquelle auf der Leiterplatte mit Hilfe wenigstens einer Kamera und einer bildverarbeitenden Steuerung eines Handling-Systems, das die SMD-Halbleiterlichtquelle greift und positioniert.

Erfindungsgemäß wird für die Positionierung der SMD-Halbleiterlichtquelle auf der Leiterplatte zunächst eine Lage eines lichtemittierenden Bereichs der SMD-Halbleiterlichtquelle innerhalb des Chips der SMD-Halbleiterlichtquelle ermittelt, und die SMD-Halbleiterlichtquelle wird anschließend in Abhängigkeit von der Lage des lichtemittierenden Bereichs auf der Leiterplatte positioniert, mit dieser verklebt und an diese angelötet.

Erfindungsgemäß wird die SMD-Halbleiterlichtquelle relativ zu definierten Referenzmarken der Leiterplatte positioniert.

Ferner ist bevorzugt, dass die Referenzmarken als Leiterbahnen oder Lötpads oder spezielle Leiterbahnstrukturen ohne elektrische Funktion verwirklicht sind.

Eine weitere bevorzugte Ausgestaltung des Verfahrens zeichnet sich dadurch aus, dass Öffnungen und/oder aus der Leiterplatte herausragende Vorsprünge der Leiterplatte und/oder die Ränder der Leiterplatte als Referenzmarken dienen.

Bevorzugt ist auch, dass diese Referenzmarken auch zur Positionierung der Leiterplatte auf einem Trägerteil, insbesondere einem Kühlkörper dienen.

Ferner ist bevorzugt, dass für die Positionierung der SMD-Halbleiterlichtquelle verwendete Referenzmarken auch für die Positionierung von optischen Bauteilen des Scheinwerfers wie einer Linse, einer katadioptrischen Optik und/oder eines Hohlspiegelreflektors an dem Trägerteil verwendet werden.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
Figur 1 ein Ausführungsbeispiel eines erfindungsgemäßen Verfahrens in Form eines Ablaufdiagramms;
Figur 2 eine Draufsicht auf eine Leiterplatte mit einer darauf positionierten SMD-Halbleiterlichtquelle mit zwei Klebepunkten;
Figur 3 eine Draufsicht entsprechend der Figur 2, aber mit einer erfindungsgemäßen Zahl und Anordnung von Klebepunkten;
Figur 4 in schematischer Form eine Draufsicht auf eine Leiterplatte und ein SMD-Halbleiterlichtquellenbauteil;
Figur 5a in schematischer Draufsicht ein SMD-Halbleiterlichtquellenbauteil;
Figur 5b in schematischer Draufsicht die Leiterplatte;
Figur 6 in schematischer Draufsicht ein weiteres SMD-Halbleiterlichtquellenbauteil; und
Figur 7 in schematischer Seitenansicht das Aufbringen des SMD-Halbleiterlichtquellenbauteils auf die Leiterplatte.

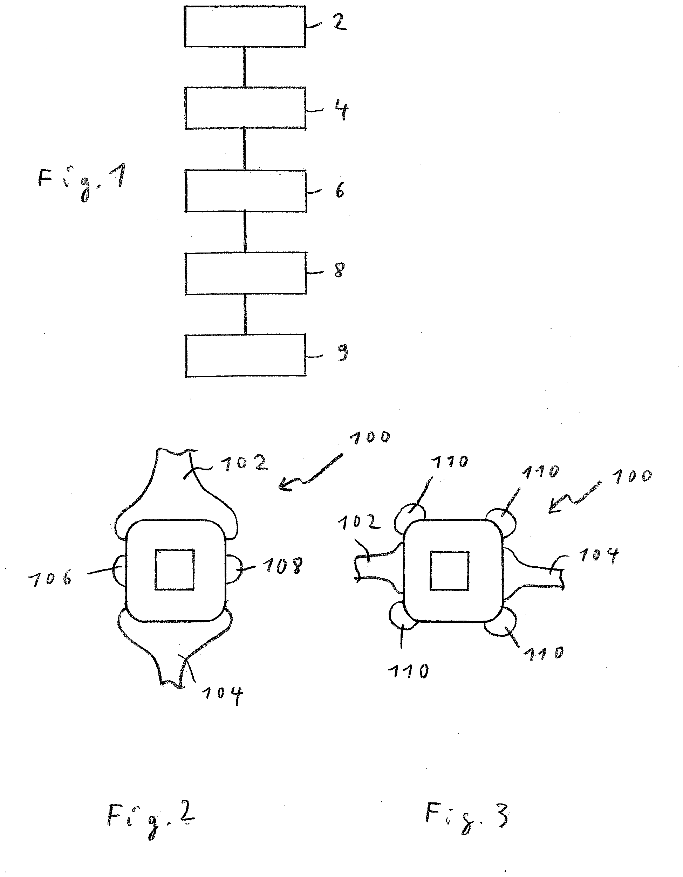

Im Einzelnen zeigt die Figur 1 eine Abfolge einzelner Verfahrensschritte eines Ausführungsbeispiels eines erfindungsgemäßen Verfahrens.

In einem Lot-Aufbringungsschritt 2 wird Lot an vorbestimmten Stellen der Leiterplatte und/oder an vorbestimmten Stellen der SMD-Halbleiterlichtquelle aufgebracht. Das Aufbringen des Lots erfolgt nach einem bekannten Verfahren, zum Beispiel durch Schablonendruck, durch sogenannte Dispenser, durch Lotformteile oder galvanisch.

In einem Kleber-Aufbringungsschritt 4 wird Kleber an vorbestimmten Stellen der Leiterplatte und/oder der SMD-Halbleiterlichtquelle aufgebracht. Dazu werden in einer Ausgestaltung Klebepunkte oder Klebeflächen auf der Leiterplatte angebracht. Alternativ oder ergänzend dazu wird der Kleber direkt auf der Rückseite des Chips der Halbleiterlichtquelle aufgebracht. Das Aufbringen erfolgt bevorzugt durch Siebdruck, Dispensen oder andere Verfahren.

In einem Positionierungsschritt 6 wird die SMD-Halbleiterlichtquelle auf der Leiterplatte in eine Position gebracht, in der in weiteren Schritten eine Lötverbindung hergestellt wird. Einzelheiten zu Ausführungsbeispielen des Positionierungsschrittes werden weiter unten noch näher erläutert. Im Positionierungsschritt 6 wird die Halbleiterlichtquelle so platziert, so dass sie in Kontakt mit dem Kleber ist.

In einem Verklebungsschritt 8 wird die SMD-Halbleiterlichtquelle in der durch den Positionierungsschritt erreichten Position mit der Leiterplatte verklebt.

In einem Lötschritt 9 erfolgt ein vorübergehendes Aufschmelzen des Lotes in einem Lötofen und Abkühlen des Lotes.

Der Verklebungsschritt 8 und der Lötschritt 9 erfolgen in einem Lötofen, wobei der Verklebungsschritt vor dem Lötschritt erfolgt. Dabei ist, dass das Temperaturprofil, also der Verlauf der Ofentemperatur über der Verweildauer der bestückten Leiterplatte im Ofen, so gesteuert wird, dass beim Aushärten des Klebers nur ein möglichst geringes Abweichen von der Sollposition auftritt.

Dies wird durch die Verwendung eines Klebers erreicht, der bereits bei unterhalb der Schmelztemperatur des Lotes liegenden Temperaturen trocknet und damit aushärtet. Das Aushärten des Klebers erfolgt dann bereits beim Vorheizen des Lötofens, also bevor das Lot aufschmilzt. An das das bei einer vergleichsweise höheren Temperatur erfolgende Aufschmelzen des Lotes schließt sich eine Abkühlung an, die innerhalb oder bevorzugt außerhalb des Lötofens erfolgt, so dass das Lot erstarrt und neben seiner elektrischen Leitungsfunktion auch zu einer festen mechanischen Verbindung zwischen Halbleiterlichtquelle und Leiterplatte beiträgt.

Durch das vor dem Aufschmelzen des Lotes erfolgende Festkleben der SMD-Halbleiterlichtquelle an der Leiterplatte wird eine wesentlich bessere Positionsgenauigkeit im fertig gelöteten Zustand erzielt. Mit den durch das Kleben erzielten geringeren und damit besseren Positionstoleranzen lassen sich effizientere Scheinwerfer fertigen.

Bei der Schrittfolge der Figur 1 erfolgt das Aufbringen des Klebers vor dem Platzieren der Halbleiterlichtquellen auf der Leiterplatte. Eine alternative Ausgestaltung des Verfahrens sieht vor, dass der Kleber nach dem Platzieren der Halbleiterlichtquellen auf die Leiterplatte aufgebracht wird.

Alternativ oder ergänzend zu der beschriebenen Verwendung eines durch Erhitzen aushärtenden Klebers wird ein durch Ultraviolettstrahlung aushärtender Kleber verwendet, der dann vor dem Aufschmelzen des Lotes mit ultraviolettem Licht bestrahlt wird. Bei einem Verkleben der SMD-Halbleiterlichtquelle mit der Leiterplatte durch einen unter Ultraviolettstrahlungseinfluss aushärtenden Kleber wird die SMD-Halbleiterlichtquelle bevorzugt solange mit dem Handlingsystem fixiert, bis der aushärtende Klebstoff eine für das Festhalten der SMD-Halbleiterlichtquelle auseichende Festigkeit erreicht hat.

Generell sind alle Klebemittel und Klebeverfahren geeignet, die eine durch Verkleben erfolgende Fixierung der SMD-Halbleiterlichtquelle auf der Leiterplatte vor dem Aufschmelzen des Lotes gestatten.

Bei der Beschreibung wurde bis zu dieser Stelle auf eine Befestigung einer einzelnen SMD-Halbleiterlichtquelle an einer Leiterplatte Bezug genommen. Es versteht sich aber, dass die Erfindung auch zu einer Befestigung mehrerer SMD-Halbleiterlichtquellen an einer gemeinsamen Leiterplatte verwendbar ist. Außerdem können sich bei der Bestückung der Leiterplatte mit einer oder mehreren SMD-Halbleiterlichtquellen bereits weitere elektronische Bauteile auf der Leiterplatte befinden, oder es kann eine Bestückung mit weiteren Bauteilen erfolgen. Das Aushärten des Klebers erfolgt dann, wenn es durch einen Temperaturschritt erfolgt, bevorzugt gemeinsam für alle Bauteile im Lötofen. Gleiches gilt auch für den Schritt des Aufschmelzens des Lotes und das anschließende Abkühlen. Die letzten beiden Schritte erfolgen auch dann für mehrere oder sämtliche Bauteile auf einer Leiterplatte gemeinsam, wenn das Ankleben jeweils bauteilindividuell erfolgte. Wenn der Kleber mittels Bestrahlung mit ultraviolettem Licht ausgehärtet wird, werden bevorzugt mehrere Lötstellen oder auch mehrere aufzuklebende Bauteile gleichzeitig bestrahlt, um die Prozesszeiten zu verkürzen.

Die Figur 2 zeigt eine Draufsicht auf eine Leiterplatte mit einer darauf positionierten SMD-Halbleiterlichtquelle 100, die von zwei Leiterbahnenden 102, 104 kontaktiert wird. Hier sind die Leiterbahnenden breiter als die Halbleiterlichtquelle, so dass nur wenig Platz für das Aufbringen des Klebers vorhanden ist. Die Figur 2 zeigt eine Befestigung mit zwei Klebepunkten 106, 108. Die beiden Klebepunkte sind an zwei einander gegenüberliegenden Seiten einer rechteckigen SMD-Halbleiterlichtquelle 100 angeordnet. Die beiden übrigen Rechteckseiten dienen zum Herstellen einer gelöteten Verbindung. Diese beiden übrigen Rechteckseiten liegen vollständig in den Leiterbahnenden.

Die Figur 3 zeigt eine erfindungsgemäße Ausgestaltung, bei der Klebepunkte 110 an den vier Ecken eines rechteckigen SMD-Halbleiterlichtquellenchips angeordnet sind. In diesem Fall erfolgt die elektrische Kontaktierung über Leiterbahnenden 102, 104, die zwischen zwei längs einer Rechteckseite der Halbleiterlichtquelle benachbarten Klebepunkten liegen.

Im Folgenden werden Einzelheiten bevorzugter Ausgestaltungen des Positionierung- / Platzierungsschrittes vorgestellt. Die Bestückung der Leiterplatte an vorbestimmten Positionen erfolgt mit Hilfe wenigstens einer Kamera und einer bildverarbeitenden Steuerung eines Handling-Systems, das die Halbleiterlichtquelle greift und positioniert, respektive platziert.

Dabei wird die SMD-Halbleiterlichtquelle zu definierten Referenzmarken der Leiterplatte positioniert und ausgerichtet.

In der einfachsten Variante erfolgt die Positionierung auf der Basis eines von einer kalibrierten Kamera aufgenommenen Bildes des einfach beleuchteten Objekts. Eine Bildverarbeitungseinheit wertet das Bild aus und leitet die Messdaten an die Anlagensteuerung und eventuelle Regelsysteme weiter.

Alternativ wird der Prozess mit einer kalibrierten Kamera und einem oder mehreren definierten Beleuchtungsmustern unterstützt und überprüft. Mit dieser aufwendigeren Apparatur können Probleme mit zufälligen starken, Reflexen reduziert oder eliminiert werden. Die Reflexe können beispielsweise von bereits aufgelöteten Bauteilen oder von Leiterbahnstrukturen stammen. Da die Beleuchtung aus mehreren Richtungen erfolgt, ergibt sich hier die Möglichkeit, Störungen in einem Bild oder auch durch den Schatten der Handlingsysteme bedingte Störungen zu eliminieren und/oder zu kompensieren.

Die erste Kamera wird dazu bevorzugt durch eine zweite Kamera ergänzt, die sich in einer definierten Lage zur ersten Kamera befindet. Mittels photogrammetrischer Bildauswertung kann auch die Orientierung der SMD-Halbleiterlichtquelle im Raum kontrolliert werden. Die beiden Kameras sehen das Objekt aus unterschiedlichen Perspektiven. Aus den Unterschieden in den Bildern lässt sich die räumliche Struktur der Bildbereiche rekonstruieren.

Die Ausrichtung erfolgt immer zu Referenzmarken auf der Platine. Solche Referenzmarken sind bevorzugt als speziell angeordnete Leiterbahnen oder Lötpads oder spezielle

Leiterbahnstrukturen ohne elektrische Funktion verwirklicht. Alternativ oder ergänzend dienen Öffnungen und/oder aus der Leiterplatte herausragende Vorsprünge der Leiterplatte und/oder die Ränder der Leiterplatte als Referenzmarken. Diese Referenzmarken dienen bevorzugt auch zur Positionierung der Leiterplatte auf einem Trägerteil. Ein solches Trägerteil ist bevorzugt ein Kühlkörper. Die Referenzmarken der SMD-Halbleiterlichtquellen werden bevorzugt auch für die Positionierung der optischen Bauteile des Scheinwerfers wie Linsen, katadioptrische Optiken und Hohlspiegelreflektoren verwendet.

Für die Positionierung der SMD-Halbleiterlichtquelle auf einer Leiterplatte wird zunächst eine Lage eines lichtemittierenden Bereichs der SMD-Halbleiterlichtquellen innerhalb des Chips ermittelt. Anschließend wird die SMD-Halbleiterlichtquelle in Abhängigkeit von der Lage des lichtemittierenden Bereichs auf der Leiterplatte positioniert, mit dieser verklebt und an diese angelötet. verbunden.

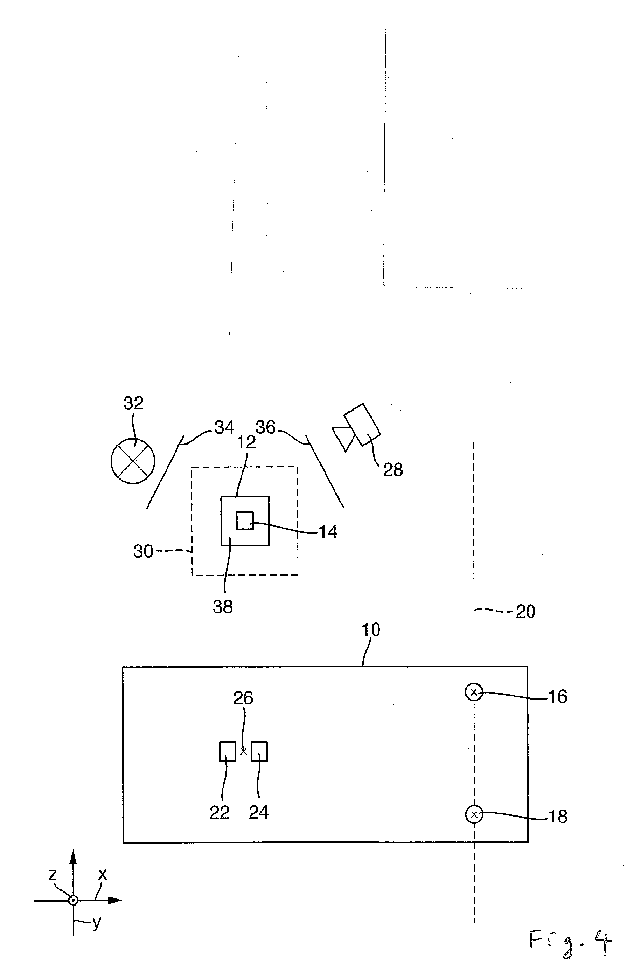

Die Figur 4 zeigt in schematischer Draufsicht entgegen einer z-Richtung die Leiterplatte 10. Des Weiteren ist eine SMD-Halbleiterlichtquelle 12 gezeigt, die den lichtemittierenden Bereich 14 aufweist.

Die in einer xy-Ebene liegenden Außenkonturen der SMD-Halbleiterlichtquelle 12 und/oder des lichtemittierenden Bereichs 14 sind in der Figur 4 im Wesentlichen quadratisch dargestellt, können aber selbstverständlich auch jede andere rechteckige Form oder andersartige geometrische Form aufweisen.

Die Leiterplatte 10 weist Referenzmarken in Form von Zentrierlöchern 16 und 18 auf, durch deren Mittelpunkte eine Gerade 20 verläuft. Die Gerade 20 dient als Referenz zur Positionierung der SMD-Halbleiterlichtquelle 12. Selbstverständlich kann die Gerade 20 auch bei anderer Anordnung der Zentrierlöcher 16 und 18 ermittelt werden. Besonders bevorzugt werden Befestigungspunkte der Leiterplatte als Referenzmarkierung verwendet. Dies hat den Vorteil dass sich auch eine exakte Positionierung bei der Verbindung der Leiterplatte 10 bezüglich eines anderen Bauteils, insbesondere bezüglich der übrigen Bestandteile eines Kraftfahrzeugscheinwerfers ergibt.

Die Leiterplatte 10 weist ferner Kontaktstellen 22 und 24 auf, die insbesondere als Lötstellen zur Kontaktierung der entsprechenden Kontakte der SMD-Halbleiterlichtquelle 12 mit der Leiterplatte 10 dienen. Des Weiteren ist eine Zielkoordinate 26 gezeigt, die sich im Bezug zur Referenz gemäß der Geraden 20 beziehungsweise der Zentrierlöcher 16 und 18 ergibt.

Mittels einer Aufnahmekamera 28 wird ein Bild 30 der SMD-Halbleiterlichtquelle beim Angleichen ihrer Ist-Position am ihre Soll-Position auf der Leiterplatte 12 aufgenommen. Die Kamera 28 ist so angeordnet, dass das Bild 30 zu der Geraden 20 justiert ist. Die Lage der Halbleiterlichtquelle in dem Bild korrespondiert daher zu ihrer Ausrichtung in Bezug auf die Zentrierlöcher 16 und 18.

Die SMD-Halbleiterlichtquelle 12 wird mittels einer Lichtquelle 32 beleuchtet, um das Bild 30 aufzunehmen. Umfasst die SMD-Halbleiterlichtquelle 12 einen Phosphorkonverter als lichtemittierenden Bereich 14, so sorgt ein Blaufilter 34 vor der Lichtquelle 32 dafür, dass die SMD-Halbleiterlichtquelle 12 mit blauem Licht beleuchtet wird. Zusätzlich sorgt ein Gelbfilter 36 dafür, dass das von dem Phosphorkonverter 14 reflektierte Licht mit einem hohen Kontrast gegenüber einem weiteren Bereich 38, der zu den Außengrenzen des SMD-Halbleiterlichtquellenbauteils 12 hin angeordnet ist, aufgenommen wird. Insbesondere wenn dieser weitere Bereich 38 aus einem im Wesentlichen schwach reflektierenden Material wie beispielsweise eine Vergussmasse wie Silikon besteht, erhöht sich der Kontrast gegenüber dem Phosphorkonverter, und damit gegenüber der lichtemittierenden Bereich, stark.

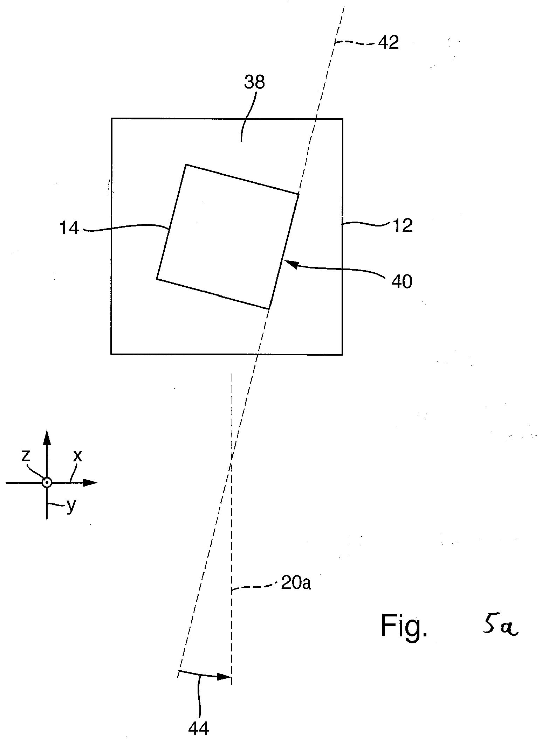

Figur 5a zeigt eine Draufsicht auf die SMD-Halbleiterlichtquelle 12 entgegen einer z-Richtung. Der lichtemittierende Bereich 14 ist sowohl zu einer Außenkontur des SMD-Halbleiterlichtquellenbauteils 12 in einer xy-Ebene als auch zu einer Parallelen 20a der Geraden 20 verdreht. Insbesondere ist eine in positiver x-Richtung angeordnete Kante 40 des lichtemittierenden Bereichs 14 sowohl zur Außenkontur des SMD-Halbleiterlichtquellenbauteils 12 als auch zu der Parallelen 20a verdreht.

In einem anderen Beispiel kann beispielsweise die Kante 40 zwar parallel zur entsprechenden Kante der Außenkontur sein, jedoch ist die SMD-Halbleiterlichtquelle 12 an seinem Ablageplatz gegenüber der Parallelen 20a verdreht, womit auch die Kante 40 gegenüber der Parallelen 20a verdreht ist.

Die Parallele 20a und die Gerade 20 geben bezüglich der Leiterplatte 10 eine Ausrichtung der Hell-Dunkel-Grenze für einen Kraftfahrzeugscheinwerfer, insbesondere für ein Abblendlicht des Kraftfahrzeugscheinwerfers, an. Mithin muss die Kante 40 zu der Geraden 20 möglichst parallel ausgerichtet werden.

Die Lage des lichtemittierenden Bereichs 14 und insbesondere der Kante 40 ist durch eine Übergangslinie 42 durch die Kante 40 zwischen dem lichtemittierenden Bereich 14 und dem weiteren Bereich 38 des SMD-Halbleiterlichtquellenbauteils 12 charakterisiert. Aus dem Bild 30 wird die Übergangslinie 42 ermittelt. Zur Ermittlung der Übergangslinie 42 werden vorliegend nicht weiter beschriebene bildanalysierende Verfahren eingesetzt. Es wird gemäß dem ersten Schritt 4 ein Drehwinkel 44 zwischen der Übergangslinie 42 und einer Referenzlinie, insbesondere der Geraden 20 oder der Parallelen 20a, ermittelt.

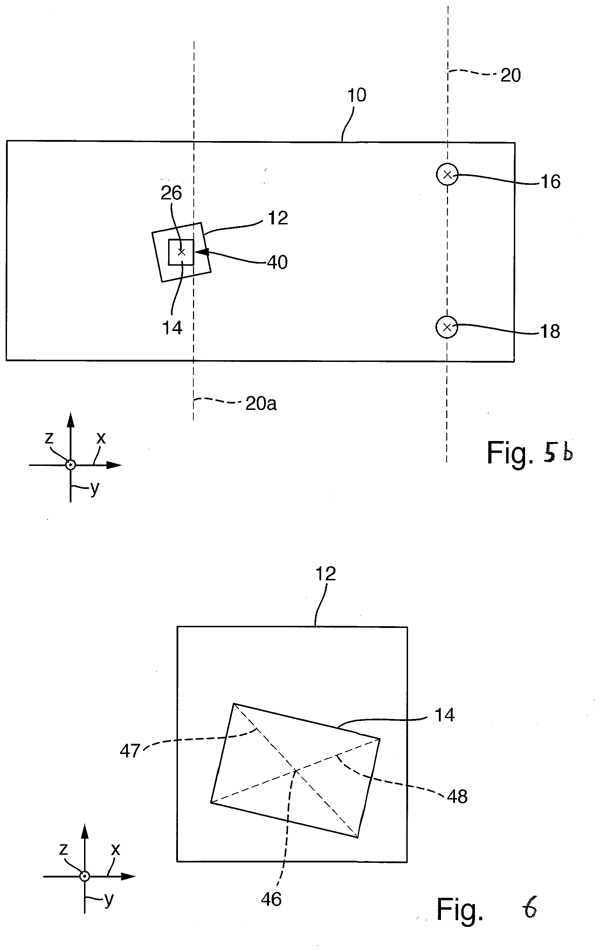

Figur 5b zeigt die Leiterplatte 10 aus der Figur 2, wobei die SMD-Halbleiterlichtquelle 12 mit ihrer Kante 40 gemäß der Figur 5a an der Parallelen 20a zu der Geraden 20 ausgerichtet ist. Zusätzlich wurde ein nachgehend erläuterter Flächenschwerpunkt des lichtemittierenden Bereichs 14 ermittelt und die SMD-Halbleiterlichtquelle 12 mit dem Flächenschwerpunkt über der Zielkoordinate 26 positioniert und die SMD-Halbleiterlichtquelle 12 mit der Leiterplatte 10 materialschlüssig verbunden. Selbstverständlich kann auch nur die Kante 40 zu der Parallelen 20a beziehungsweise zu der Geraden 20 verdreht werden, ohne dass der Flächenschwerpunkt zur Positionierung des SMD-Halbleiterlichtquellenbauteils 12 herangezogen wird. So können mehrere SMD-Halbleiterlichtquellenbauteile 12 auf der Leiterplatte 10 angeordnet werden.

Selbstverständlich sind auch SMD-Halbleiterlichtquellenbauteile 12 mit mehreren lichtemittierenden Bereichen 14 durch die hier beschriebenen Verfahren verarbeitbar, wobei für die mehreren lichtemittierenden Bereiche 14 sowohl eine gemeinsame Linie 42 ermittelbar ist als auch ein gemeinsamer Flächenschwerpunkt ermittelbar ist.

Figur 6 zeigt in schematischer Draufsicht ein weiteres SMD-Halbleiterlichtquellenbauteil 12, bei dem der lichtemittierende Bereich 14 sowohl verdreht zu der Außenkontur des SMD-Halbleiterlichtquellenbauteils 12 ist, als auch mit seinem Flächenschwerpunkt 46 außerhalb des Flächenschwerpunkts der Außenkontur des SMD-Halbleiterlichtquellenbauteils 12 ist. Der Flächenschwerpunkt 46 kann beispielsweise durch Verbindungslinien 47 und 48 der jeweils gegenüberliegenden Ecken des lichtemittierenden Bereichs 14 ermittelt werden. Für andere Formen des lichtemittierenden Bereichs 14 ergibt sich der Flächenschwerpunkt durch eine andere Berechnungsart. Wie zuvor zu Figur 5b erläutert, dient der Flächenschwerpunkt 46 dazu, die SMD-Halbleiterlichtquelle 12 mit dem ermittelten Flächenschwerpunkt 46 an einer xy-Koordinate gemäß der Zielkoordinate 26 zu positionieren und materialschlüssig mit der Leiterplatte 10 zu verbinden.

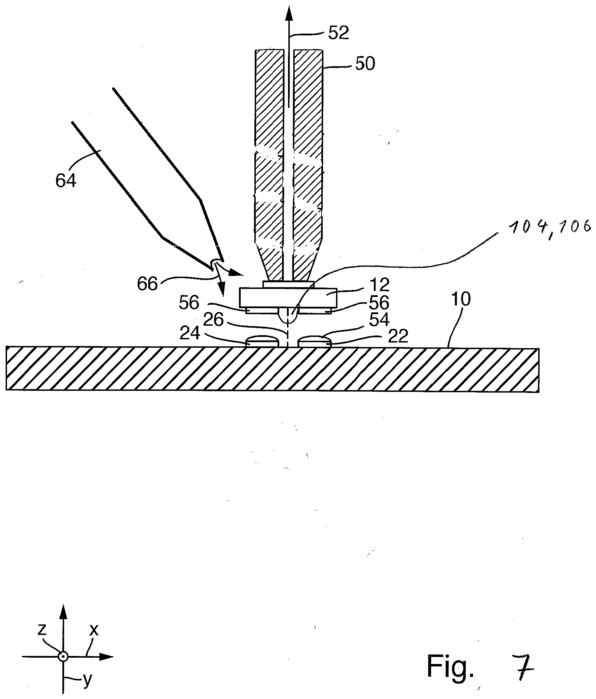

Figur 7 zeigt in schematischer Seitenansicht in einer y-Richtung die Positionierung der SMD-Halbleiterlichtquelle 12 auf der Leiterplatte 10. Die SMD-Halbleiterlichtquelle 12 wird von einer Haltevorrichtung 50, die ein Teil des Handlingsystems ist, über der Zielkoordinate 26 gehalten.

Die Haltevorrichtung 50 ist beispielsweise eine Vakuumpipette, die über einen Unterdruck gemäß einem Pfeil 52 die SMD-Halbleiterlichtquelle 12 an deren Oberfläche hält.

Eine Verdrehung der SMD-Halbleiterlichtquelle 12 um den Drehwinkel 44 kann beispielsweise mittels einer Drehvorrichtung am Aufnahmeort für die SMD-Halbleiterlichtquelle 12 erfolgen, woraufhin die Haltevorrichtung 50 die SMD-Halbleiterlichtquelle 12 in einem nachfolgenden Schritt, an dem Aufnahmeort aufnimmt und an der Zielkoordinate 26 positioniert. Alternativ kann auch die Aufnahmevorrichtung 50 eine Drehung um den Drehwinkel 44 entweder am Aufnahmeort, an der Zielkoordinate 26 oder dazwischen liegend durchführen.

Nach der Positionierung des SMD-Halbleiterlichtquellenbauteils 12 an der Koordinate 26 wird die SMD-Halbleiterlichtquelle 12 mit den Kontaktstellen 22 und 24 stoffschlüssig verbunden.

Die stoffschlüssige Verbindung erfolgt zunächst durch Kleben. Beim in der Figur 7 dargestellten Beispiel sind dazu Klebepunkte 104, 106 (also Kleber) auf die SMD-Halbleiterlichtquelle 12 aufgebracht worden, um beim Absetzen der SMD-Halbleiterlichtquellen mit ihren Kontakten 56 auf den Lötkontaktstellen 22, 24 der Leiterplatte eine Klebeverbindung zwischen der Leiterplatte 10 und der SMD-Halbleiterlichtquelle 12 herzustellen.

Die Kontaktstellen 22, 24 sind hier mit einer Lötpaste 54 versehen. Die Kontaktstellen 22 und 24 sind beispielsweise aus Kupfer und deren Oberfläche ist verzinnt. Bei der Lötpaste 54 kann es sich um eine chemisch oder galvanisch applizierte Zinnschicht handeln. Die Lötpaste 54 wird bevorzugt zuvor aufgedruckt.

Zur materialschlüssigen Verbindung des SMD-Halbleiterlichtquellenbauteils 12 mit der Leiterplatte 112 entgegen der z-Richtung an der Zielposition 26 zu der Leiterplatte 10 hin durch die Haltevorrichtung 50 bewegt. Insbesondere kann die Haltevorrichtung 50 eine Druckkraft entgegen der z-Richtung ausüben. Während des gesamten Lötprozesses wird die SMD-Halbleiterlichtquelle 12 zur präzisen Anordnung von der Haltevorrichtung 50 gehalten. Erst nach einem Erkalten des Lots beendet die Haltevorrichtung 50 den Haltevorgang.

Ein Ultraviolettstrahler 64 erzeugt Ultraviolettstrahlung 66, mit der der Kleber an den Klebepunkten 104, 106 nach dem Aufsetzen der SMD-Halbleiterlichtquelle auf die Leiterplatte ausgehärtet wird.

Anschließend wird die mit aufgeklebter SMD-Halbleiterlichtquelle 12 bestückte Leiterplatte 10 in einen nicht dargestellten Lötofen eingebracht, in dem das Lot aufgeschmolzen wird. Der Lötvorgang muss nicht in einem Lötofen erfolgen und kann zum Beispiel auch durch induktives Erwärmen der Lötkontakte erfolgen. Wesentlich ist jedoch immer, dass ein Aufschmelzen des Lotes erst nach dem Erzeugen der geklebten Verbindung erfolgt, so dass eine Positionsveränderung der SMD-Halbleiterlichtquelle, die mit einem Aufschwimmen im flüssigen Lot einhergeht, verhindert wird.

## Patentansprüche

1. Verfahren zum Befestigen einer rechteckigen SMD-Halbleiterlichtquelle (12) auf einer Leiterplatte (10) eines Kraftfahrzeugscheinwerfers mit den Schritten: Aufbringen eines Lotes an vorbestimmten Stellen der Leiterplatte (10) und/oder an vorbestimmten Stellen der SMD-Halbleiterlichtquelle (12); Positionieren der SMD-Halbleiterlichtquelle auf der Leiterplatte in einer Position (26), in der in weiteren Schritten eine Lötverbindung hergestellt wird, und, in einem Lötschritt, vorübergehendes Aufschmelzen und Abkühlen des Lotes; wobei vor dem Aufschmelzen des Lotes Kleber an vorbestimmten Stellen (14, 110) der Leiterplatte und/oder der SMD-Halbleiterlichtquelle aufgebracht wird, wobei die SMD-Halbleiterlichtquelle in der durch den Positionierungsschritt erreichten Position in einem Verklebungsschritt mit der Leiterplatte verklebt wird, wobei der Verklebungsschritt und der Lötschritt in einem Lötofen erfolgen, wobei ein Kleber verwendet wird, der bereits bei unterhalb der Schmelztemperatur des Lotes liegenden Temperaturen trocknet und damit aushärtet und wobei ein Verlauf der Ofentemperatur über einer Verweildauer der bestückten Leiterplatte im Ofen so gesteuert wird, dass beim Aushärten des Klebers nur ein möglichst geringes Abweichen von der Sollposition auftritt und wobei das Aufschmelzen des Lotes bei einer vergleichsweise höheren Temperatur erfolgt, **dadurch gekennzeichnet, dass** das Positionieren der Halbleiterlichtquelle auf der Leiterplatte mit Hilfe wenigstens einer Kamera (28) und einer bildverarbeitenden Steuerung eines Handling-Systems erfolgt, das die SMD-Halbleiterlichtquelle greift und positioniert, wobei für die Positionierung der SMD-Halbleiterlichtquelle auf der Leiterplatte zunächst eine Lage eines lichtemittierenden Bereichs (14) der SMD-Halbleiterlichtquelle innerhalb des Chips der SMD-Halbleiterlichtquelle ermittelt wird und die SMD-Halbleiterlichtquelle anschließend in Abhängigkeit von der Lage des lichtemittierenden Bereichs auf der Leiterplatte positioniert, mit dieser verklebt und an diese angelötet wird, wobei die Positionierung relativ zu definierten Referenzmarken (16, 18) der Leiterplatte erfolgt und wobei die SMD-Halbleiterlichtquelle (12) solange mit einem zur Platzierung der SMD-Halbleiterlichtquelle auf der Leiterplatte verwendeten Handlingsystem gehalten wird, bis der aushärtende Klebstoff eine für das Festhalten der SMD-Halbleiterlichtquelle ausreichende Festigkeit entwickelt hat, wobei die vorbestimmten Stellen (110) vier Ecken des rechteckigen SMD-Halbleiterlichtelements (12) sind, und dass eine elektrische Kontaktierung über Leiterbahnenden (102, 104) erfolgt, die zwischen zwei längs einer Rechteckseite der SMD-Halbleiterlichtquelle (12) benachbarten Klebepunkten liegen.

2. Verfahren nach Anspruch 1, **dadurch gekennzeichnet, dass** die Referenzmarken als Leiterbahnen oder Lötpads oder spezielle Leiterbahnstrukturen ohne elektrische Funktion verwirklicht sind.

3. Verfahren nach Anspruch 1 oder 2, **dadurch gekennzeichnet, dass** Öffnungen und/oder aus der Leiterplatte herausragenden Vorsprünge der Leiterplatte und/oder die Ränder der Leiterplatte als Referenzmarken dienen.

4. Verfahren nach Anspruch 1, **dadurch gekennzeichnet, dass** diese Referenzmarken auch zur Positionierung der Leiterplatte auf einem Trägerteil, insbesondere einem Kühlkörper dienen.

5. Verfahren nach Anspruch 4, **dadurch gekennzeichnet, dass** für die Positionierung der SMD-Halbleiterlichtquelle verwendete Referenzmarken auch für die Positionierung von optischen Bauteilen des Scheinwerfers wie einer Linse, einer katadioptrischen Optik und/oder eines Hohlspiegelreflektors an dem Trägerteil verwendet werden.

6. Verfahren nach einem der vorhergehenden Ansprüche, **dadurch gekennzeichnet, dass** ein durch Ultraviolettstrahlung (66) aushärtender Kleber verwendet wird, der vor dem Aufschmelzen des Lotes mit ultraviolettem Licht bestrahlt wird.

7. Verfahren nach einem der vorhergehenden Ansprüche, **dadurch gekennzeichnet, dass** das Aufbringen des Klebers vor dem Platzieren der Halbleiterlichtquellen auf der Leiterplatte erfolgt.

8. Verfahren nach einer der Ansprüche 1 - 7, **dadurch gekennzeichnet, dass** der Kleber nach dem Platzieren der Halbleiterlichtquellen auf die Leiterplatte aufgebracht wird.

## Claims

1. Method for mounting a rectangular SMD semiconductor light source (12) on a printed circuit board (10) of a motor vehicle headlamp, comprising the steps of: applying a solder at predetermined points of the printed circuit board (10) and/or at predetermined points of the SMD semiconductor light source (12); positioning the SMD semiconductor light source on the printed circuit board in a position (26) in which a soldered connection is produced in further steps, and, in a soldering step, temporarily melting and cooling the solder; adhesive being applied at predetermined points (14, 110) of the printed circuit board and/or of the SMD semiconductor light source before the melting of the solder, the SMD semiconductor light source, in the position achieved by the positioning step, being bonded to the printed circuit board in a bonding step, the bonding step and the soldering step being carried out in a soldering furnace, an adhesive being used which already dries and thus cures at temperatures below the melting temperature of the solder, and a profile of the furnace temperature being controlled over a residence time of the populated printed circuit board in the furnace such that only the smallest possible deviation from the target position occurs when the adhesive cures, and the solder being melted at a comparatively higher temperature, **characterized in that** the positioning of the semiconductor light source on the printed circuit board is carried out by means of at least one camera (28) and an image-processing controller of a handling system which grips and positions the SMD semiconductor light source, at least one position of a light-emitting region (14) of the SMD semiconductor light source within the chip of the SMD semiconductor light source firstly being determined for the positioning of the SMD semiconductor light source on the printed circuit board, and the SMD semiconductor light source subsequently being positioned on the printed circuit board according to the position of the light-emitting region, and being bonded and soldered to said printed circuit board, the positioning being carried out relative to defined reference marks (16, 18) of the printed circuit board, and the SMD semiconductor light source (12) being held by means of a handling system, which is used for placing the SMD semiconductor light source on the printed circuit board, until the cured adhesive has developed sufficient strength for securing the SMD semiconductor light source, the predetermined points (110) being four corners of the rectangular SMD semiconductor light element (12), and **in that** electrical contact is made via conductor track ends (102, 104) which lie between two adhesive points that are adjacent along a rectangle side of the SMD semiconductor light source (12).

2. Method according to claim 1, **characterized in that** the reference marks are in the form of conductor tracks or solder pads or special conductor track structures without an electrical function.

3. Method according to claim 1 or 2, **characterized in that** openings and/or projections of the printed circuit board protruding from the printed circuit board and/or the edges of the printed circuit board serve as reference marks.

4. Method according to claim 1, **characterized in that** these reference marks also serve to position the printed circuit board on a carrier part, in particular a heat sink.

5. Method according to claim 4, **characterized in that** reference marks used for the positioning of the SMD semiconductor light source are also used for positioning optical components of the headlamp, such as a lens, a catadioptric optical system and/or a concave mirror reflector, on the carrier part.

6. Method according to any of the preceding claims, **characterized in that** an adhesive curable by ultraviolet radiation (66) is used, which is irradiated with ultraviolet light before the melting of the solder.

7. Method according to any of the preceding claims, **characterized in that** the adhesive is applied before the semiconductor light sources are placed on the printed circuit board.

8. Method according to any of claims 1-7, **characterized in that** the adhesive is applied to the printed circuit board after the semiconductor light sources have been placed.

## Revendications

1. Procédé permettant la fixation d'une source de lumière à semi-conducteurs SMD (12) rectangulaire sur une carte de circuits imprimés (10) d'un phare de véhicule automobile, comportant les étapes: d'application d'une soudure à des emplacements prédéterminés de la carte de circuits imprimés (10) et/ou à des emplacements prédéterminés de la source de lumière à semi-conducteurs SMD (12); de positionnement de la source de lumière à semi-conducteurs SMD sur la carte de circuits imprimés dans une position (26) dans laquelle, lors d'une étape supplémentaire, une liaison par brasage est produite, et, lors d'une étape de brasage, fusion temporaire et refroidissement de la soudure; dans lequel, avant la fusion de la soudure, de la colle est appliquée à des emplacements prédéterminés (14, 110) de la carte de circuits imprimés et/ou de la source de lumière à semi-conducteurs SMD, dans lequel la source de lumière à semi-conducteurs SMD est collée à la carte de circuits imprimés lors d'une étape de collage dans la position atteinte par l'étape de positionnement, dans lequel l'étape de collage et l'étape de brasage sont effectuées dans un four de brasage, dans lequel une colle est utilisée, laquelle sèche déjà à une température inférieure à la température de fusion de la soudure et durcit ainsi, et dans lequel une évolution de la température de four est commandée sur une durée de séjour de la carte de circuits imprimés équipée dans le four de sorte que, lors du durcissement de la colle, seul un écart aussi faible que possible par rapport à la position de consigne se produit, et dans lequel la fusion de la soudure est effectuée à une température comparativement plus élevée, **caractérisé en ce que** le positionnement de la source de lumière à semi-conducteurs sur la carte de circuits imprimés est effectuée à l'aide d'au moins une caméra (28) et d'un dispositif de commande de traitement d'images d'un système de manipulation qui saisit et positionne la source de lumière à semi-conducteurs SMD, dans lequel, pour le positionnement de la source de lumière à semi-conducteurs SMD sur la carte de circuits imprimés, une position d'une région émettrice de lumière (14) de la source de lumière à semi-conducteurs SMD à l'intérieur de la puce de la source de lumière à semi-conducteurs SMD est d'abord déterminée et la source de lumière à semi-conducteurs SMD est ensuite positionnée, en fonction de la position de la région émettrice de lumière, sur la carte de circuits imprimés, collée avec celle-ci et brasée sur celle-ci, dans lequel le positionnement est effectué par rapport à des marquages de référence (16, 18) définis de la carte de circuits imprimés et dans lequel la source de lumière à semi-conducteurs SMD (12) est maintenue avec un système de manipulation utilisé pour la mise en place de la source de lumière à semi-conducteurs SMD sur la carte de circuits imprimés jusqu'à ce que la colle durcissable ait développé une résistance suffisante pour le maintien de la source de lumière à semi-conducteurs SMD, dans lequel les emplacements prédéterminés (110) sont les quatre coins de l'élément de lumière à semi-conducteurs SMD (12) rectangulaire, et **en ce qu'**une mise en contact électrique est effectuée par l'intermédiaire d'extrémités de piste conductrice (102, 104) situées entre deux points de collage voisins le long d'une face de rectangle de la source de lumière à semi-conducteurs SMD (12).

2. Procédé selon la revendication 1, **caractérisé en ce que** les marquages de référence sont réalisés sous forme de pistes conductrices ou de plots de soudure ou de structures de piste conductrice spéciales sans fonction électrique.

3. Procédé selon la revendication 1 ou 2, **caractérisé en ce que** des ouvertures et/ou des saillies de la carte de circuits imprimés faisant saillie depuis la carte de circuits imprimés et/ou les bords de la carte de circuits imprimés servent de marquages de référence.

4. Procédé selon la revendication 1, **caractérisé en ce que** lesdits marquages de référence servent également pour le positionnement de la carte de circuits imprimés sur une pièce de support, en particulier un dissipateur thermique.

5. Procédé selon la revendication 4, **caractérisé en ce que** les marquages de référence utilisés pour le positionnement de la source de lumière à semi-conducteurs SMD sont également utilisés pour le positionnement de composants optiques du phare, tels qu'une lentille, un système optique catadioptrique et/ou un réflecteur à miroir creux, sur la pièce de support.

6. Procédé selon l'une quelconque des revendications précédentes, **caractérisé en ce qu'**une colle durcissable par rayonnement ultraviolet (66) est utilisée, laquelle est irradiée par une lumière ultraviolette avant la fusion de la soudure.

7. Procédé selon l'une quelconque des revendications précédentes, **caractérisé en ce que** l'application de la colle est effectuée avant la mise en place de la source de lumière à semi-conducteurs sur la carte de circuits imprimés.

8. Procédé selon l'une des revendications 1 à 7, **caractérisé en ce que** la colle est appliquée sur la carte de circuits imprimés après la mise en place de la source de lumière à semi-conducteurs.
